Europäisches Patentamt

European Patent Office

Office européen des brevets

(11) Publication number: **0 196 149**
**B1**

# EUROPEAN PATENT SPECIFICATION

<table>
<tr><td>(45) Date of publication of the patent specification:<br>13.09.89</td><td>(51) Int. Cl.⁴: <b>G 01 R 1/073</b></td></tr>
</table>

(21) Application number: **86300441.2**

(22) Date of filing: **23.01.86**

(54) Electrical interface arrangements.

<table>
<tr>
<td>
(30) Priority: <b>05.03.85 GB 8505566</b>

(43) Date of publication of application:<br><b>01.10.86 Bulletin 86/40</b>

(45) Publication of the grant of the patent:<br><b>13.09.89 Bulletin 89/37</b>

(84) Designated Contracting States:<br><b>AT BE CH DE FR IT LI LU NL SE</b>

(56) References cited:<br><b>DE-B-2 657 910</b><br><b>US-A-2 918 648</b>
</td>
<td>
(73) Proprietor: <b>MARCONI INSTRUMENTS LIMITED,<br>Longacres Hatfield Road, St. Albans<br>Hertfordshire, AL4 0JN (GB)</b>

(72) Inventor: <b>Jenner, Frank Harry, 26, Millhouse Lane,<br>St. Albans Hertfordshire (GB)</b>

(74) Representative: <b>Tolfree, Roger Keith, The General<br>Electric Co. p.l.c. Patent Department GEC-<br>Marconi Research Centre West Hanningfield<br>Road, Great Baddow, Chelmsford Essex CM2<br>8HN (GB)</b>
</td>
</tr>
</table>

LIBER, STOCKHOLM 1989

## Description

The invention relates to an electrical interface arrangement in which an array of conductive probes is brought into electrical contact with a circuit board to facilitate the electrical testing of it, and/or of electrical components mounted on the circuit board. As circuit boards, and the components which are mounted upon them, become more complex, greater and greater numbers of conductive probes are required to make contact to all of the circuit nodes which need to be tested. The present invention seeks to provide an electrical interface arrangement in which conductive probes can be used to make contact with both faces of a circuit board.

In DE-B-2 657 910, there is disclosed a test apparatus in which a circuit board to be tested is brought into electrical contact with an array of conductive probes connected to electrical test equipment by evacuating a chamber, of which the circuit board itself forms one wall. It is also known from US-A-2 918 648 to avoid bending a thin circuit board under test by using "back-up fingers" which bear against the side of the board opposite to that contacted by the test probes.

According to this invention, an electrical interface arrangement for coupling a circuit board to electrical test equipment includes two arrays of conductive probes connectable to said test equipment, which arrays are spaced apart from each other and at least one of which is linked to a movable wall portion of an evacuable chamber, a reduction in pressure of which serves to move the two arrays towards each other so as to sandwich a circuit board between them; and means for making electrical paths between the electrical test equipment and one array of probes which is associated with one surface of the circuit board by action related to said reduction in pressure. In operation one array of conductive probes is movable to a significant extent to allow easy insertion and removal of a circuit board, and to facilitate this, preferably said one array of conductive probes is mounted on a removable wall portion of the chamber. The provision of means for making and breaking the electrical paths between this array and the input/output port avoids the need for long permanently connected flexible electrical leads to be provided for that array which is temporarily moved aside whilst a circuit board is inserted or removed.

Preferably again, said one array is mounted on a hinged wall portion with respect to a wall portion on which the other array is mounted so that both arrays are aligned with each other when the hinged wall portion is in a first predetermined position. This is not to say that individual probes in the two arrays are aligned with each other, as the positions of the probes is determined by the location of the circuit points which are to be contacted and tested, but it is important that both arrays are aligned with the circuit board, and hence with each other.

The use of the two arrays of probes serves to overcome a difficulty which can be experienced when an array of conductive probes is used to make electrical contact with one side of a circuit board in the conventional manner, as the contact force exerted by each probe in order to make a low impedance connection with a circuit board multiplies very rapidly as large numbers of probes are used, causing distortion of what is generally a thin and flexible circuit board. By providing another array to exert a reaction force on the other side of the circuit board, this difficulty is avoided, and it also enables otherwise inaccessible circuit points to be tested. Double-sided and multilayer circuit boards are now becoming increasingly common, and the use of the two arrays enables both surfaces of a circuit board to be thoroughly tested in a single operation. It not only reduces the testing time, but enables more complex electrical tests to be performed involving nodes and components on both sides of the board simultaneously.

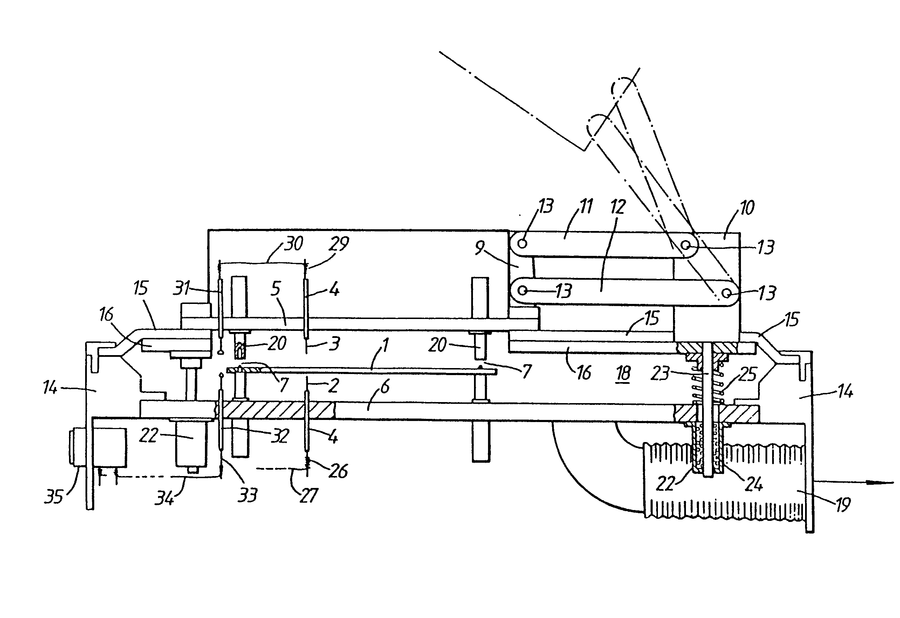

The invention is further described by way of example with reference to the accompanying drawing, which illustrates in a diagrammatic fashion an electrical interface arrangement.

A circuit board 1 to be tested is shown mounted within the electrical interface 1 which is illustrated in the drawing. The circuit board may be of the kind commonly termed a printed circuit board in which conductive tracks are formed on one or more sides of a rigid or flexible insulating substrate. Even in the case of a nominally rigid substrate, the board is generally so thin that it has some degree of flexure if its area is of any appreciable size. As the circuits which are required to be formed upon substrates of this kind become increasingly more and more complex, it is becoming more common to fabricate such a circuit as a multilayer circuit board. In such a board of the latter kind, two or more thin substrates each carrying tracks are bonded together to form a thick composite sandwich. It is extremely difficult to test such a circuit board, especially if it is carrying components on one or both of its outer surfaces, by means of electrically conductive probes which are brought into contact with just one of its surfaces. Thus, in the electrical interface arrangement illustrated in the drawings, two arrays of conductive probes are provided, although only one probe in each array is illustrated for the sake of clarity. Thus, what can be conveniently termed the lower surface of the circuit board 1 is contacted by an exemplary conductive probe 2 and the upper surface can be contacted by an exemplary probe 3. In both cases the probe itself is mounted in a spring-loaded telescopic fashion within a housing 4 which is firmly located within respective apertures in bed plates 5 and 6. The circuit board 1 is supported by four spring-loaded location pins 7 of which only two are visible in the drawing. In practice, one such pin is located in the corner of a circuit board to be tested. The pins 7 are such as to support the circuit board 1 away from the lower bed plate 6 by an amount necessary to give clearance to any components which might be mounted on the lower side of the circuit board 1 and to accommodate of course, the telescopic action of the probes 2.

The upper bed plate 5 is mounted so that it can be moved away from the circuit board 1 to allow access to the upper surface of the board, and to facilitate its easy insertion and removal. To this end, the bed plate 5 is mounted on a hinge structure consisting of two hinge brackets 9 and 10 which are linked by two rigid couplings 11 and 12, these couplings being pivotally coupled by four pivots 13. The nature of the hinge is such as to allow very good access to the interior of the electrical interface arrangement when the lid is in the raised position, as is indicated diagrammatically by the broken lines, and to give a substantially parallel action when the lid is at its closed position.

The two bed plates 5 and 6 form part of an evacuatable chamber, the walls of which are defined by a frame structure 14 which encircles the lower array 2. The bed plate 5 rests upon the upper surface of a flexible apertured diaphragm 15 which in the closed position is sandwiched between it and an upper frame 16. The flexible diaphragm enables a vacuum-tight enclosure to be formed when the upper bed plate is lowered on to it. The upper array of conductive probes 3 is then drawn towards the lower array 2 of conductive probes so as to sandwich the circuit board 1 between them by a suction effect which is achieved by applying a partial vacuum to the enclosure 18 so formed via an extraction port 19.

It will be noted that as the circuit board 1 under test forms no part of the wall of the evacuated chamber, it is of little consequence if it is provided with apertures e.g. by the omission of components - in a conventional suction apparatus, such apparatus can cause some difficulty. It is to preserve the parallel action of the motion of the upper bed plate 5 when it is drawn towards the lower bed plate 6 under the action of the suction effect, that the special hinge arrangement having the two couplings 11 and 12 is provided. Precise alignment between the two arrays is achieved by means of four spring-loaded posts 20 which co-operate with the upstanding pins 7 when the array 3 is lowered on to the board 1 so as to make contact therewith.

The posts 20 are guided on to the locating pins 7 by the restraining action of four linear bearings 22 which consist each of a shaft 23 which slides within a cylinder 24 mounted on the lower surface of the bed plate 6. Compression springs 25, of which only one is illustrated, serve to force apart the two bed plates 5 and 6 when the suction vacuum is released.

It will be appreciated that in order to conduct the electrical testing of the circuit board 1, it is necessary to connect both arrays 2 and 3 to an electrical test equipment. To facilitate this, electrical leads 27 are connected directly to the terminations 26 of the outer ends of the conductive probes forming part of the array 2, and the other ends of such leads 27 are typically connected to the electrical test equipment via an electrical interconnector 35 represented only diagramatically, but which is mounted on a lower portion of the frame 14. In order to conveniently connect the upper array 3 of electrical probes to the test equipment, the outer terminations 29 are linked by means of conductive wires 30 to a further set of spring-loaded contacts 31 mounted on the bed plate 5, and these co-operate with a similar array of contacts 32 mounted on the lower bed plate 6. Electrical connection between the contacts 31 and 32 is made at the same time as the upper bed plate 5 is drawn down by the suction formed within the chamber 18. Consequently, electrical connections, as represented by leads 34 are made to the lower terminations 33 of the contacts 32 in a manner analogous to the connections made to the terminations 26 by the leads 27. This completely avoids the need to take electrical leads from the upper array 3 out through or over the hinge arrangement and enables all of the electrical connections to be fed to electrical connectors 35 mounted physically adjacent to each other on the lower portion of the frame 14. This further avoids passing wires through a vacuum chamber also eliminating flexing of loose wires. Such connectors 35, of which only one is visible, represent the input /output ports which couple the electrical interface arrangement to the electrical test equipment.

## Claims

1. An electrical interface arrangement for coupling a circuit board (1) to electrical test equipment including two arrays (5, 6) of conductive probes (2, 3) connectable to said test equipment which arrays are spaced apart from each other and at least one of which is linked to a movable wall portion of an evacuable chamber, a reduction in pressure of which serves to move the two arrays towards each other so as to sandwich the circuit board between them; and means (30, 31, 33, 34) for making electrical paths between the electrical test equipment and one array of probes which is associated with one surface of the circuit board by action related to said reduction in pressure.

2. An arrangement as claimed in claim 1 and wherein means are provided for breaking said electrical paths by action related to the restoration of pressure in said chamber during which said arrays move away from each other.

3. An arrangement as claimed in claim 1 or 2 and wherein one array of conductive probes is mounted on a removable wall portion of the chamber.

4. An arrangement as claimed in claim 3 and wherein said one array is mounted on a hinged wall portion with respect to a wall portion on which the other array is mounted so that both arrays are aligned with each other when the hinged wall portion is in a first predetermined position.

5. An arrangement as claimed in claim 1, 2, 3 or 4 and wherein an input/output port (35) is provided to couple the two arrays of conductive probes to the electrical test equipment, the port being connected to one of said arrays via a set of contacts (31, 33) which make when the two arrays move towards each other, and which break when said reduction in pressure is released.

6. An arrangement as claimed in any of claims 1 to 5 and wherein the two arrays are mounted in a spring loaded fashion on respective bed plates, each plate of which carries means (20) for clamping the circuit board firmly when the two arrays are drawn towards each other.

7. An arrangement as claimed in claim 6 and wherein the clamping means (7) includes means for co-operating with apertures in the circuit board to ensure that the circuit board is accurately aligned with both of said arrays.

**Patentansprüche**

1. Elektrische Anschlußanordnung zum Koppeln einer Schaltplatine (1) mit elektrischer Testausrüstung, einschließlich zweier Gruppierungen (5, 6) von leitfähigen Sonden (2, 3), welche mit der Testausrüstung verbindbar sind, wobei die Gruppierungen voneinander Abstand haben und mindestens eine von ihnen mit einem bewegbaren Wandabschnitt einer evakuierbaren Kammer verbunden ist, wobei eine Druckabsenkung in derselben dazu dient, die beiden Gruppierungen aufeinander zu zu bewegen, um so die Schaltplatine zwischen ihnen einzuschließen, und einschließlich Mitteln (30, 31, 33, 34) zum Herstellen elektrischer Wege zwischen der elektrischen Testausrüstung und einer Gruppierung von Sonden, die einer Fläche der Schaltplatine zugeordnet ist, durch mit der Druckabsenkung in Zusammenhang stehender Betätigung.

2. Anordnung nach Anspruch 1 und bei der Mittel vorgesehen sind, zur Unterbrechung der elektrischen Wege durch auf die Wiederherstellung des Druckes in der Kammer bezogene Betätigung, während der die Gruppierungen sich voneinander wegbewegen.

3. Anordnung nach Anspruch 1 oder 2 und bei der eine Gruppierung von leitfähigen Sonden an einem entfernbaren Wandabschnitt der Kammer angebracht ist.

4. Anordnung nach Anspruch 3 und bei der die eine Gruppierung an einem Wandabschnitt befestigt ist, der mit Bezug auf einen Wandabschnitt, an dem die andere Gruppierung angebracht ist, gelenkig ist, so daß beide Anordnungen miteinander ausgerichtet sind, wenn der gelenkige Wandabschnitt sich in einer ersten vorbestimmten Lage befindet.

5. Anordnung nach Anspruch, 1, 2, 3 oder 4 und bei der ein Eingangs/Ausgangs-Anschluß (35) vorgesehen ist, um die beiden Gruppierungen aus leitfähigen Sonden mit der elektrischen Testausrüstung zu verbinden, wobei der Anschluß mit der einen Gruppierung über eine Reihe von Kontakten (31, 33) verbunden ist, die schließen, wenn die beiden Gruppierungen sich aufeinander zu bewegen, und unterbrechen, wenn die Druckabsenkung aufgehoben wird.

6. Anordnung nach einem der Ansprüche 1 - 5 und bei der die beiden Gruppierungen in einer federgespannten Weise bezüglich Grundplatten angebracht sind, von denen jede Platte Mittel (20) zum Festklemmen der Schaltplatine trägt, wenn die beiden Gruppierungen aufeinander zu gezogen werden.

7. Anordnung nach Anspruch 6 und bei der die Klemmittel mit Öffnungen in der Schaltplatine zusammenwirkende Mittel (7) enthalten, um sicherzustellen, daß die Schaltplatine mit beiden Gruppierungen genau ausgerichtet ist.

**Revendications**

1. Dispositif d'interface électrique permettant de coupler une plaquette de circuit (1) à un équipement de contrôle électrique, comportant deux ensembles (5, 6) de sondes conductrices (2, 3) que l'on peut connecter audit équipement de contrôle, lesdits ensembles étant séparés l'un de l'autre et au moins l'un d'entre eux étant relié à une partie de paroi mobile d'une chambre dans laquelle on peut faire le vide, la réduction de pression ainsi réalisée servant à déplacer les deux ensembles l'un vers l'autre de manière qu'ils prennent en sandwich entre eux la plaquette de circuit; et des moyens (30, 31, 33, 34) servant à établir des trajets électriques entre l'équipement de contrôle électrique et un premier ensemble de sondes qui est associé à une première surface de la plaquette de circuit, par l'action qui est associée à ladite réduction de pression.

2. Dispositif selon la revendication 1, où des moyens sont prévus pour interrompre lesdits trajets électriques du fait de l'action associée au rétablissement de la pression dans la chambre, pendant lequel lesdits ensembles s'écartent l'un de l'autre.

3. Dispositif selon la revendication 1 ou 2, où un premier ensemble de sondes conductrices est monté sur une partie de paroi amovible de la chambre.

4. Dispositif selon la revendication 3, où ledit premier ensemble est monté sur une partie de paroi articulée par charnière par rapport à la partie de paroi sur laquelle l'autre ensemble est monté, de façon que les deux ensembles soient alignés l'un avec l'autre lorsque la partie de paroi articulée par charnière se trouve dans une première position prédéterminée.

5. Dispositif selon la revendication 1, 2, 3 ou 4, où un moyen d'entrée-sortie (35) est prévu pour coupler les deux ensembles de sondes conductrices à l'équipement de contrôle électrique, le moyen d'entrée-sortie étant connecté à l'un desdits ensembles via un groupe de contacts (31, 32) qui se ferment lorsque les deux ensembles sont déplacés l'un vers l'autre et qui s'ouvrent lors du relâchement de ladite réduction de pression.

6. Dispositif selon l'une quelconque des revendications 1 à 5, où les deux ensembles sont montés à l'aide de ressorts élastiques sur des plaques d'appui respectives, chacune de ces plaques portant des moyens (20) permettant de serrer fermement la plaquette de circuit lorsque les deux ensembles sont attirés l'un vers l'autre.

7. Dispositif selon la revendication 6, où lesdits moyens de serrage comprennent des moyens (7) qui coopèrent avec des ouvertures ménagées dans la plaquette de circuit afin d'assurer que la plaquette de circuit est exactement alignée avec les deux dits ensembles.